# EUROPÄISCHE PATENTSCHRIFT

(11) **EP 2 826 114 B1**
(45) Veröffentlichungstag und Bekanntmachung des Hinweises auf die Patenterteilung: **20.11.2019**
(21) Anmeldenummer: 13707310.2
(22) Anmeldetag: 20.02.2013
(51) Int. Cl.: H02B 1/052

(54) **MONTAGEEINHEIT UND VERFAHREN ZUR MONTAGE EINER MONTAGESCHIENE AN EINER MONTAGEPLATTE FÜR EINEN SCHALTSCHRANK**
MOUNTING DEVICE AND METHOD FOR MOUNTING A MOUNTING RAIL TO A MOUNTING PLATE OF AN ELECTRICAL CABINET
UNITÉ DE MONTAGE ET PROCEDE DE MONTAGE D'UN RAIL SUPPORT POUR UNE PLATINE D'UNE ARMOIRE ÉLECTRIQUE

(30) Priorität: 15.03.2012 DE 102012102170
(43) Veröffentlichungstag der Anmeldung: 21.01.2015
(73) Patentinhaber: Krones AG, 93073 Neutraubling (DE)
(72) Erfinder: PETER, Michael, 93073 Neutraubling (DE)
(74) Vertreter: Schuhbießer, Irmgard Gertrud
(86) Internationale Anmeldenummer: PCT/EP2013/053311
(87) Internationale Veröffentlichungsnummer: WO 2013/135467

(56) Entgegenhaltungen:
- EP-A1- 2 369 700
- EP-A2- 0 794 602
- WO-A1-00/62387
- DE-U1- 9 413 971
- FR-A1- 2 571 183
- US-B1- 6 378 825

## Beschreibung

Die vorliegende Erfindung bezieht sich auf eine Montageeinheit und ein Verfahren zur Montage einer Montageschiene an einer Montageplatte für einen Schaltschrank.

Herkömmlicherweise werden für eine elektrische Steuerung von Maschinen elektrische Geräte verwendet, welche in einem Schaltschrank eingebaut sind. In dem Schaltschrank sind die elektrischen Geräte üblicherweise auf Montageschienen, wie beispielsweise Hutschienen oder C-Schienen montiert. Hierbei sollen die elektrischen Geräte, insbesondere Reihenklemmen, Relais, Schütze, usw., zunächst auf der Montageschiene aufgeklemmt werden. Danach werden die Hutschienen an einer Montageplatte des Schaltschranks montiert.

WO 00/62387 A1 zeigt ein Stützmodul für elektrische Geräte.

EP 2 369 700 A1 zeigt eine Montageeinheit, bei welcher ein Kopplungselement zur Kopplung mit einer Montageschienenöffnung an einem Rand der Montageschienenöffnung in Richtung der Länge der Montageschiene verhakbar ist.

DE 296 02 505 U1 offenbart eine Hutschiene als Teil eines Baugruppenträgersystems, mit welcher eine festere Verbindung zwischen einer Hutschiene und einer daran anzuschließenden Montageplatte geschaffen sein soll.

Es ist zur Vereinfachung und damit der zeitlichen Verkürzung der Montage eines Schaltschranks wünschenswert, Montageschienen mit elektrischen Geräten vollständig zu bestücken, bevor die Montageschienen tatsächlich an der Montageplatte des Schaltschranks befestigt werden. Derzeit müssen jedoch, je nach Bestückung der Montageschienen mit elektrischen Geräten, einige der elektrischen Geräte wieder Tel.: +49 (0)941 630 45 750 Fax: +49 (0)941 630 45 751 mail@schuhbiesser.de www.schuhbiesser.de demontiert werden, damit die Montageschiene mit der Montageplatte verschraubt werden kann. Dadurch ist zum Teil kein Vormontieren der Klemmen an der Montageschiene möglich oder es sind viele Arbeitsgänge doppelt auszuführen. Dies erhöht zum einen die Montagekosten und zum anderen den Platzbedarf für die elektrischen Geräte im Schaltschrank. Dadurch vergrößert sich auch der Platzbedarf für den Schaltschrank, was wiederum die Material- und Raumkosten erhöht.

Daher ist es Aufgabe der vorliegenden Erfindung, eine Montageeinheit und ein Verfahren zur Montage einer Montageschiene an einer Montageplatte für einen Schaltschrank bereitzustellen, mit welchen die zuvor genannten Probleme gelöst werden können. Insbesondere soll eine Montageeinheit und ein Verfahren zur Montage einer Montageschiene an einer Montageplatte für einen Schaltschrank bereitgestellt werden, bei welchen eine einfache und schnelle Verbindung zwischen Montageschiene und Montageplatte hergestellt werden kann. Beispielsweise soll es nicht notwendig sein, elektrische Geräte zum Befestigen der Montageschiene zu demontieren oder Platz für elektrische Geräte freizulassen.

Diese Aufgabe wird durch eine Montageeinheit zur Montage einer Montageschiene für elektrische Geräte an einer Montageplatte für einen Schaltschrank nach Patentanspruch 1 gelöst.

Mit der Montageeinheit ist es möglich, dass eine Montageschiene, insbesondere eine Hutschiene, C-Schiene, usw., an einem Arbeitsplatz zunächst mit elektrischen Geräten, insbesondere Reihenklemmen, Relais, Schütze, usw., bestückt wird und dann, ohne Demontage der elektrischen Geräte, an einer Montageplatte eines Schaltschranks montierbar ist. Dadurch ist eine Abkopplung der Montage der Montageschienen an der Montageplatte bzw. im Schaltschrank von der Bestückung der Montageschienen möglich. Dies bewirkt eine kürzere Durchlaufzeit bei der Herstellung des Schaltschranks.

Zudem kann aufgrund der Montageeinheit die Montageschiene und damit auch der Platz im Schaltschrank maximal ausgenutzt werden. Dies hat eine Reduktion des Platzbedarfs des Schaltschranks und damit auch des Platzbedarfs einer Maschine zur Folge, für deren Steuerung der Schaltschrank benötigt wird. Letztendlich ergibt sich dadurch auch eine Kostensenkung für den Schaltschrank, die Maschine und den benötigten Aufstellungsraum.

Vorteilhafte weitere Ausgestaltungen der Montageeinheit sind in den abhängigen Patentansprüchen angegeben.

Bevorzugt weist die Montageeinheit zudem eine Montageeinheitöffnung zur Aufnahme eines Montageplatten-Befestigungselements zur Befestigung der Montageeinheit an der Montageplatte auf, wobei das Kopplungselement zum Koppeln der Montageeinheit mit einer Montageschienenöffnung ausgestaltet ist. Dadurch kann die bestückte Montageschiene mit Hilfe der Montageeinheit einfach an die Montageplatte montiert werden, ohne dass vorher elektrische Geräte demontiert werden müssen.

Darüber hinaus kann die Montageeinheit zudem einen wannenförmigen Grundkörper aufweisen, der eine U-förmige Aussparung zum Umgreifen der Montageschiene hat. Diese Ausgestaltung der Montageeinheit ist insbesondere vorteilhaft, wenn die Montageschiene eine Hutschiene ist, da durch die U-förmige Aussparung ein weiterer Formschluss der Montageeinheit mit der Montageschiene realisiert wird.

Hierbei hat das Kopplungselement ein Snapelement zum Bilden einer Snapverbindung mit einer Montageschienenöffnung, wobei das Snapelement zwei blattfederförmige Teile hat, die an ihrem einen Ende jeweils mit einem Grundkörper der Montageeinheit verbunden sind und an ihrem anderen Ende einen Snaphaken aufweisen, wie in den abhängigen Ansprüchen beschrieben. Beispielsweise sind die zwei blattfederförmigen Teile durch eine vom Snaphaken zum Grundkörper hin konisch zulaufende Nut beabstandet voneinander, wobei die Snaphaken jeweils von der Nut abgewandt angeordnet sind. Dadurch kann eine sehr schnelle, einfache und sichere Montage der bestückten, und auch einer unbestückten, Montageschiene mit Hilfe der Montageeinheit an der Montageplatte gewährleistet werden, indem die Montageschiene auf die Montageplatte aufgeschnappt wird, ohne dass vorher elektrische Geräte demontiert werden müssen.

Es ist möglich, dass die Montageeinheit zudem einen Steg aufweist, aus welchem ein Bolzen auskragt, wobei der Bolzen dem Kopplungselement zugeordnet ist. Mit Hilfe der Bolzen der Montageeinheit kann eine noch verdrehsicherere Montage der Montageschiene an der Montageeinheit und damit auch an der Montageplatte bewerkstelligt werden.

Es ist von Vorteil, dass die Montageeinheit zwei Kopplungselemente und/oder zwei Stege aufweist. Diese Ausführungsform kann die Montage der Montageschiene an der Montageeinheit und damit auch an der Montageplatte noch verdrehsicherer gestalten.

Vorteilhafter Weise ist in dem Grundkörper ein erstes Kopplungselement, ein erster Steg mit Bolzen, ein zweiter Steg mit Bolzen und ein zweites Kopplungselement benachbart zueinander in einer Reihe angeordnet, wobei die Reihe quer zu der U-förmigen Aussparung angeordnet ist. Diese Ausführungsform dient ebenfalls der Erhöhung der Verdrehsicherheit der Montage der Montageschiene an der Montageplatte.

Gemäß einer Variante kann die Montageeinheitöffnung zwischen dem ersten Steg mit Bolzen und dem zweiten Steg mit Bolzen angeordnet sein. Alternativ kann die Montageeinheit auch eine erste und eine zweite Montageeinheitöffnung aufweisen, und an dem Grundkörper sind die erste Montageeinheitöffnung, das erste Kopplungselement, der erste Steg mit Bolzen, der zweite Steg mit Bolzen, das zweite Kopplungselement und die zweite Montageeinheitöffnung benachbart zueinander in einer Reihe angeordnet.

Es ist möglich, dass eine Montageplatte für einen Schaltschrank mindestens eine zuvor beschriebene Montageeinheit aufweist, wobei die Montageeinheit zur Montage an einer Hutschiene oder einer C-Schiene für elektrische Geräte dient.

Es ist auch möglich, dass ein System für einen Schaltschrank mindestens eine zuvor beschriebene Montageplatte, an welcher eine Montageeinheit montiert ist, und eine Montageschiene aufweist, an welcher mindestens ein elektrisches Gerät montiert ist, wobei die Montageschiene mit der Montageeinheit an der Montageplatte befestigbar ist.

Die Aufgabe wird zudem durch ein Verfahren zur Montage einer Montageschiene an einer Montageplatte für einen Schaltschrank nach Patentanspruch 11 gelöst.

Es ist von Vorteil, dass bei dem Schritt des Montierens das Kopplungselement und ein Bolzen, der aus einem Steg der Montageeinheit auskragt, an der Montageschienenöffnung aufgenommen werden.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Nachfolgend ist die Erfindung unter Bezugnahme auf die beiliegende Zeichnung und anhand eines Ausführungsbeispiels näher beschrieben. Es zeigen:
Fig. 1 eine dreidimensionale Ansicht eines Schaltschranks, in welchem eine Montageschiene mit Hilfe einer Montageeinheit gemäß einem ersten Ausführungsbeispiel montiert ist;
Fig. 2 eine dreidimensionale Ansicht der Montageeinheit gemäß dem ersten Ausführungsbeispiel;
Fig. 3 eine Draufsicht auf die Montageeinheit gemäß dem ersten Ausführungsbeispiel;
Fig. 4 eine Untersicht unter die Montageeinheit gemäß dem ersten Ausführungsbeispiel;
Fig. 5 eine Draufsicht auf eine Montageplatte, an welcher eine Montageschiene mittels der Montageeinheit gemäß dem ersten Ausführungsbeispiel montiert ist;
Fig. 6 eine dreidimensionale Ansicht der Montageschiene, an welcher Reihenklemmen und die Montageeinheit gemäß dem ersten Ausführungsbeispiel montiert sind;
Fig. 7 eine weitere dreidimensionale Ansicht der Montageschiene, an welcher die Reihenklemmen und die Montageeinheit gemäß dem ersten Ausführungsbeispiel montiert sind;
Fig. 8 eine Schnittansicht der Montageschiene, an welcher Reihenklemmen und die Montageeinheit gemäß dem ersten Ausführungsbeispiel montiert sind;
Fig. 9 eine Untersicht unter die Montageschiene mit Reihenklemmen und Montageeinheit von Fig. 8;
Fig. 10 eine weitere Schnittansicht der Montageschiene mit Reihenklemmen und Montageeinheit von Fig. 8;
Fig. 11 ein Flussdiagramm eines Verfahrens zur Montage einer Montageschiene an einer Montageplatte für einen Schaltschrank gemäß dem ersten Ausführungsbeispiel;
Fig. 12 eine dreidimensionale Ansicht einer Montageeinheit gemäß einem zweiten Ausführungsbeispiel;
Fig. 13 eine Draufsicht auf die Montageeinheit gemäß dem zweiten Ausführungsbeispiel;
und
Fig. 14 eine Untersicht unter die Montageeinheit gemäß dem zweiten Ausführungsbeispiel.

In den Figuren sind gleiche oder funktionsgleiche Elemente, sofern nichts anderes angegeben ist, mit denselben Bezugszeichen versehen.

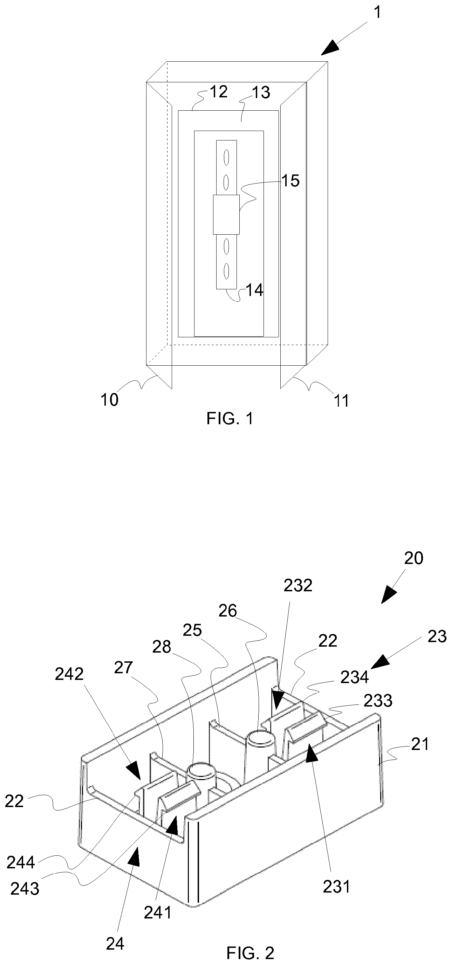

Fig. 1 zeigt einen Schaltschrank 1 mit einer linken Tür 10, einer rechten Tür 11, einer Montageplatte 12, einem Leitungskanal 13 und einer Montageschiene 14, auf welcher schematisch dargestellte elektrische Geräte 15 montiert sind. Die Montageschiene 14 kann beispielsweise eine Hutschiene, eine C-Schiene, usw. sein. Die elektrischen Geräte 15 umfassen beispielsweise Reihenklemmen, Sicherungsautomaten, Motorschutzschalter, Relais, Schütze, usw. Der Schaltschrank 1 kann demzufolge ein Elektroverteiler eines Gebäudes sein. Der Schaltschrank 1 kann jedoch auch elektrische Geräte 15 aufweisen, welche beispielsweise zur Steuerung einer Maschine, insbesondere einer nicht dargestellten Behälterbehandlungsanlage zur Behandlung von Behältern zur Aufnahme eines Produkts, einer Schleifmaschine, einer Lüftungsanlage, einer Fertigungsstraße, usw. dienen.

Fig. 2 zeigt eine Montageeinheit 20, welche in dem Schaltschrank 1 in Fig. 1 zur Montage der Montageschiene 14 an der Montageplatte 12 verwendet ist.

Die Montageeinheit 20 hat ein wannenförmiges Gehäuse 21 mit zwei Aussparungen 22, welche jeweils an den Stirnseiten des wannenförmigen Gehäuses 21 angeordnet sind. In dem wannenförmigen Gehäuse 21 ist ein erstes Kopplungselement 23 und ein zweites Kopplungselement 24 sowie ein erster Steg 25 mit einem daraus auskragenden Bolzen 26 und ein zweiter Steg 27 mit einem daraus auskragenden Bolzen 28 angeordnet. Das erste Kopplungselement 23 hat ein erstes Snapelement 231 und ein zweites Snapelement 232. Das zweite Kopplungselement 24 hat ein erstes Snapelement 241 und ein zweites Snapelement 242. Die Snapelemente 231, 232, 241, 242 sind jeweils als blattfederförmiges Teil ausgebildet, dass an seinem einen Ende jeweils einen Snaphaken 233, 234, 243, 244 aufweist. Der erste Bolzen 26 kragt aus dem ersten Steg 25 in zwei Richtungen aus. Das heißt, der erste Bolzen 26 ist in seiner Achsrichtung länger als der erste Steg 25 in dieser Richtung hoch ist. Zudem hat der erste Bolzen 26 einen größeren Durchmesser als der erste Steg 25 in der Richtung des Durchmessers des ersten Bolzens 26 dick ist. Der zweite Steg 27 und der zweite Bolzen 28 sind auf die gleiche Weise ausgeführt wie der erste Steg 25 und der erste Bolzen 26. Demzufolge kragt der zweite Bolzen 28 aus dem zweiten Steg 27 in zwei Richtungen aus. Das heißt, der zweite Bolzen 28 ist in seiner Achsrichtung länger als der zweite Steg 27 in dieser Richtung hoch ist. Zudem hat der zweite Bolzen 28 einen größeren Durchmesser als der zweite Steg 27 in der Richtung des Durchessers des zweiten Bolzens 28 dick ist.

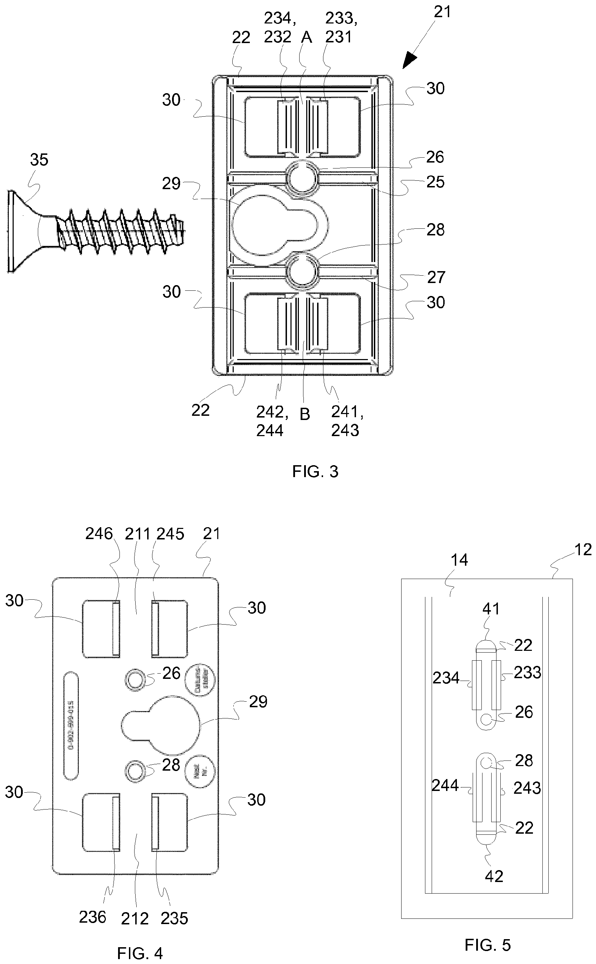

In Fig. 3 ist in einer Draufsicht auf die Montageeinheit 20 zusätzlich zu dem Gehäuse 21, den Aussparungen 22, den Snapelementen 231, 232, 241, 242 des ersten und zweiten Kopplungselements 23, 24 (Fig. 2), dem ersten Steg 25, dem ersten Bolzen 26, dem zweiten Steg 27 und dem zweiten Bolzen 28 auch eine erste Montageeinheitöffnung 29 und vier zweite Montageeinheitöffnungen 30 sowie eine erste und zweite Nut A, B ersichtlich. In die erste Montageeinheitöffnung 29 kann ein Kopplungselement 35, wie beispielsweise eine Schraube, eine Klammer, ein Snapelement, ein Blindniet usw., derart aufgenommen werden, dass die Montageeinheit 20 an der Montageplatte 12 befestigt werden kann. An den zweiten Montageeinheitöffnungen 30 sind jeweils die Snapelemente 231, 232, 241, 242 angeordnet. Die erste Nut A ist zwischen den Snapelementen 231, 232 angeordnet. Die zweite Nut B ist zwischen den Snapelementen 241, 242 angeordnet. Die erste und zweite Nut A, B ist auch in Bezug auf Fig. 4 näher beschrieben.

Fig. 4 zeigt eine Untersicht unter die Montageeinheit 20. Hier sind jeweils die anderen Enden 235, 236, 245, 246 der Snapelemente 231, 232, 241, 242 (Fig. 3) dargestellt, die an dem Grundkörper 21 bei den zweiten Montageeinheitöffnungen 30 befestigt sind. Bei dem ersten Kopplungselement 23 sind die Snapelemente 231, 232 (Fig. 3) über ein als Steg ausgebildetes Trennelement 211 des Grundkörpers 21 voneinander getrennt. Somit sind das erste und zweite Snapelement 231, 232 (Fig. 3) des ersten Kopplungselements 23 benachbart zueinander angeordnet. Zwischen dem ersten und zweiten Snapelement 231, 232 bzw. seinen blattfederförmigen Teilen ist demzufolge die Nut A (Fig. 3) gebildet, die von den Snaphaken 233, 234 (Fig. 2, Fig. 3) des ersten Kopplungselements 23 zum anderen Ende 235, 236 des ersten und zweiten Snapelements 231, 232 hin konisch zulaufend ausgebildet ist. Die Snaphaken 233, 234 (Fig. 2, Fig. 3) sind jeweils von der Nut A (Fig. 3) abgewandt angeordnet.

Zudem sind bei dem zweiten Kopplungselement 24 die Snapelemente 241, 242 (Fig. 3) über ein als Steg ausgebildetes Trennelement 212 des Grundkörpers 21 voneinander getrennt. Somit sind das erste und zweite Snapelement 241, 242 (Fig. 3) des zweiten Kopplungselements 24 benachbart zueinander angeordnet. Zwischen dem ersten und zweiten Snapelement 231, 232 (Fig. 3) bzw. seinen blattfederförmigen Teilen ist demzufolge die Nut B (Fig. 3) gebildet, die von den Snaphaken 243, 244 (Fig. 2, Fig. 3) des zweiten Kopplungselements 24 zum anderen Ende 245, 246 des ersten und zweiten Snapelements 241, 242 des zweiten Kopplungselements 24 hin konisch zulaufend ausgebildet ist. Die Snaphaken 243, 244 (Fig. 2, Fig. 3) sind jeweils von der Nut B (Fig. 3) abgewandt angeordnet.

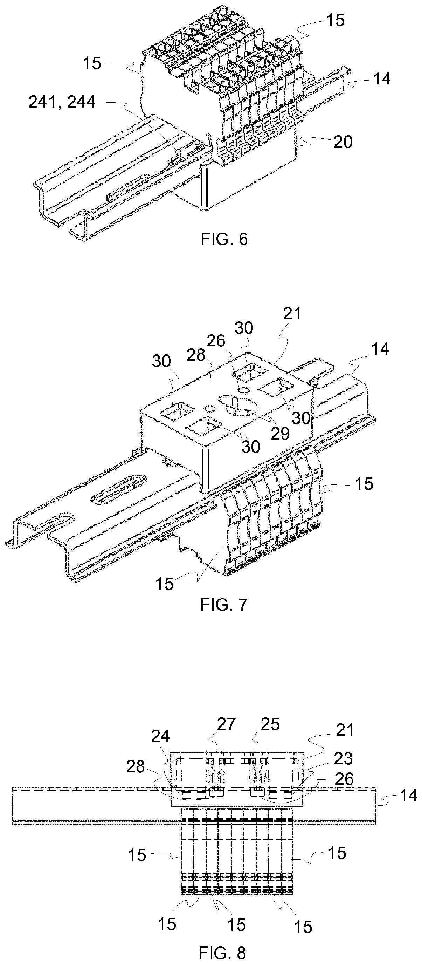

Fig. 5 zeigt eine Draufsicht auf eine Montageschiene 14 ohne elektrische Geräte 15, wobei die Montageschiene 14 mittels einer Montageeinheit 20 an der Montageplatte 12 befestigt ist. Hier sind die Snaphaken 233, 234 durch eine erste Montageschienenöffnung 41 geführt, und mit der ersten Montageschienenöffnung 41 verhakt. Dadurch bildet das Kopplungselement 23 (Fig. 2) einen Formschluss mit der Montageschiene 14. Zudem ragt der erste Bolzen 26 in die erste Montageschienenöffnung 41. Darüber hinaus sind die Snaphaken 243, 244 des zweiten Snapelements 24 durch eine zweite Montageschienenöffnung 42 geführt und verhaken sich mit der zweiten Montageschienenöffnung 42. Dadurch bildet auch das Kopplungselement 24 (Fig. 2) einen Formschluss mit der Montageschiene 14. Zudem ragt der zweite Bolzen 28 in die zweite Montageschienenöffnung 42. Bei der in Fig. 5 dargestellten Lösung ist der Grundkörper 21 bei der Aussparung 22 an, genauer gesagt unter, der ersten Montageschienenöffnung 41 angeordnet. Analog ist die andere Aussparung 22 des Grundkörpers 21 unter der zweiten Montageschienenöffnung 42 angeordnet. Das heißt, die Montageeinheit 20 umgreift die Montageschiene 14, wie auch besser aus Fig. 6 ersichtlich. Auch diese Ausgestaltung trägt zum Formschluss zwischen Montageeinheit 20 und Montageschiene 14 bei.

Fig. 6 veranschaulicht die Montageschiene 14, die mit mehreren elektrischen Geräten 15 bestückt ist, die hier Reihenklemmen 15 sind. In Fig. 6 und den nachfolgenden Figuren sind der Übersichtlichkeit halber nicht alle Reihenklemmen 15 mit einem Bezugszeichen versehen. Die Montageschiene 14 ist auf die Montageeinheit 20 montiert. In Fig. 6 ist dargestellt, dass das Snapelement 241 bzw. sein Snaphaken 244 eine Snapverbindung mit der Montageschiene 14, genauer gesagt einer ihrer Montageschienenöffnungen, bildet. Die anderen Snapelemente 231, 232, 241 bzw. ihre Snaphaken 233, 234, 243 sind in Fig. 6 nicht zu sehen. Wegen der Snapverbindung kann auch davon gesprochen werden, dass die Montageschiene 14 auf die Montageeinheit 20 aufgesnappt ist.

Fig. 7 zeigt die Anordnung aus Montageschiene 14, Reihenklemmen 15 und Montageeinheit 20 aus Fig. 6 von unten. In dem in Fig. 7 gezeigten Zustand ist in die erste Montageeinheitöffnung 29 noch kein Montageplatten-Befestigungselement 35 (Fig. 3) eingeführt, mit welchem die Montageeinheit 20 an einer Montageplatte 12 befestigt werden kann.

Fig. 8 veranschaulicht die Anordnung und Größenverhältnisse des ersten und zweiten Kopplungselements 23, 24 gegenüber dem ersten Bolzen 26 und dem zweiten Bolzen 28 in einer Schnittansicht. Der erste und zweite Bolzen 26, 28 sind demzufolge jeweils kürzer als die Kopplungselemente 23, 24. Zudem ist in dieser Schnittansicht das Größenverhältnis von Montageeinheit 20 und Reihenklemmen 15 und/oder zur Montageschiene 14 ersichtlich.

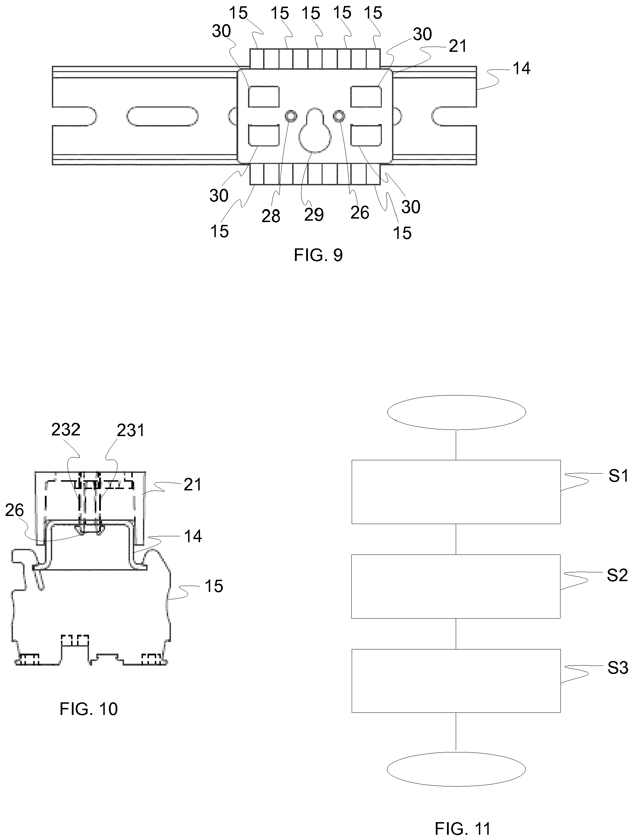

Fig. 9 zeigt eine Untersicht unter die Anordnung von Reihenklemmen 15 an der Montageschiene 14, auf welcher die Montageeinheit 20 aufgesnappt ist, von Fig. 6. Hier ist unter anderem auch dargestellt, wie die erste Montageschieneneinheitöffnung 29 der Montageeinheit 20 relativ zur Montageschiene 14 angeordnet ist, die hier eine Hutschiene ist.

Fig. 10 zeigt eine weitere Schnittansicht, in welcher genauer dargestellt ist, wie die Montageeinheit 20 die Montageschiene 14 umgreift, wenn die Montageschiene 14 eine Hutschiene ist und wenn die Snapelemente 231, 232 des Kopplungselements 23 in die erste Montageschienenöffnung 41 eingreifen und mit ihr eine Snapverbindung bilden.

Ein Verfahren zur Montage einer Montageschiene 14 an einer Montageplatte 12 für einen Schaltschrank 1 ist in Fig. 11 schematisch dargestellt. Demzufolge kann die Montageschiene 14 bei einem Schritt S1 mit mindestens einem elektrischen Gerät 15 bestückt werden. Unabhängig davon kann bei einem Schritt S2 die Montageeinheit 20 mit dem Montageplatten-Befestigungselement 35 an der Montageplatte 12 befestigt werden. Hierbei wird das Montageplatten-Befestigungselement 35 an der ersten Montageeinheitöffnung 29 aufgenommen. Sind der Schritt S1 und der Schritt S2 nacheinander und/oder zumindest teilweise gleichzeitig oder ist der Schritt S2 vor dem Schritt S1 durchgeführt, kann die Montageschiene 14 bei einem Schritt S3 an der Montageeinheit 20 befestigt werden. Hierbei können das erste und/oder das zweite Kopplungselement 23, 24 der Montageeinheit 20 in die Montageschienenöffnungen 41, 42 eingreifen. Bei dem Schritt S3 können das erste und zweite Kopplungselement 23, 24 und der erste und zweite Bolzen 26, 28 in den Montageschienenöffnungen 41, 42 aufgenommen werden, wie in Fig. 5 veranschaulicht. Danach ist das Verfahren beendet.

Der Schritt S3 kann jedoch auch vor dem Schritt S1 oder dem Schritt S2 ausgeführt werden. Das heißt die Reihenfolge der Schritte S1 bis S3 ist beliebig.

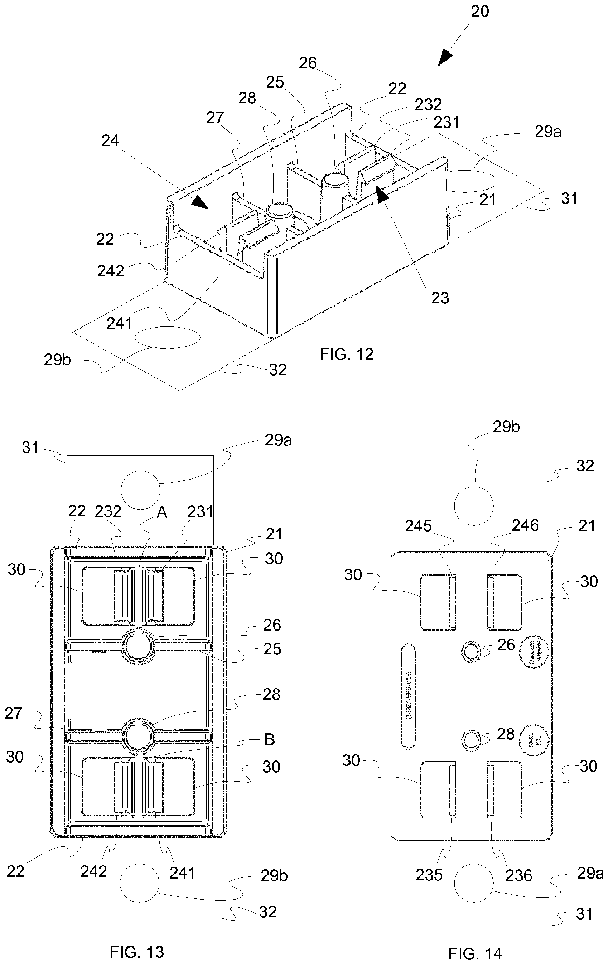

Fig. 12 zeigt eine Montageeinheit 20 gemäß einem zweiten Ausführungsbeispiel. Die Montageeinheit 20 gemäß diesem Ausführungsbeispiel ist in weiten Teilen gleich der Montageeinheit 20 des ersten Ausführungsbeispiels aufgebaut, so dass im Folgenden nur die Unterschiede zwischen dem ersten und diesem Ausführungsbeispiel beschrieben sind. Bei diesem Ausführungsbeispiel hat die Montageeinheit 20 anstelle einer ersten Montageeinheitöffnung 29 zwischen dem ersten Steg 25 und dem zweiten Steg 27 zwei erste Montageeinheitöffnungen 29a, 29b. Die beiden ersten Montageeinheitöffnungen 29 sind außerhalb des wannenförmigen Grundkörpers 21 an zwei Montageeinheitlaschen 31, 32 angeordnet. Dies ist noch besser aus der Draufsicht in Fig. 13 auf die Montageeinheit 20 und der Untersicht in Fig. 14 unter die Montageeinheit 20 ersichtlich.

Demzufolge ist in Fig. 12 bis Fig. 14 die erste Montageeinheitöffnung 29a benachbart zum ersten Kopplungselement 23 angeordnet, welches wiederum benachbart zum ersten Steg 25 mit dem ersten Bolzen 26 angeordnet ist. Der erste Steg 25 mit dem ersten Bolzen 26 ist zudem benachbart zum zweiten Steg 27 mit dem zweiten Bolzen 28 angeordnet. Der zweite Steg 27 mit dem zweiten Bolzen 28 ist außerdem benachbart zum zweiten Kopplungselement 24 angeordnet, welches wiederum zur ersten Montageeinheitöffnung 29b benachbart angeordnet ist.

Alle zuvor beschriebenen Ausgestaltungen der Montageeinheit und des Verfahrens können einzeln oder in allen möglichen Kombinationen Verwendung finden. Die Merkmale des ersten und zweiten Ausführungsbeispiels sind beliebig miteinander kombinierbar. Zusätzlich sind insbesondere folgende Modifikationen denkbar.

Die in den Figuren dargestellten Teile sind schematisch dargestellt und können in der genauen Ausgestaltung von den in den Figuren gezeigten Formen abweichen, solange deren zuvor beschriebenen Funktionen gewährleistet sind. Insbesondere sind die Form und Größe der ersten und zweiten Montageeinheitöffnungen 29, 29a, 29b, 30 geeignet wählbar. Zudem ist insbesondere die Länge der Bolzen 26, 28 und die Länge der Kopplungselemente 23, 24 geeignet wählbar. Darüber hinaus kann auch insbesondere die Form und Größe des Grundkörpers 21 geeignet gewählt werden.

Die Größenverhältnisse der dargestellten Montageeinheit 20 sind insoweit beliebig, dass eine sichere und weitestgehend spielfreie und/oder verdrehsichere Montage der mit elektrischen Geräten 15 bestückten Montageschiene 14 an der Montageplatte 12 eines elektrischen Schaltschranks 1 möglich ist.

Insbesondere können die Kopplungselemente 23, 24 der Montageeinheit 20 anders ausgeführt sein, als in den Figuren dargestellt. Das heißt, die Kopplungselemente 23, 24 können anders ausgeformte und/oder mehr oder weniger Snaphaken 233, 234, 243, 244 usw. aufweisen. Insbesondere müssen die Kopplungselemente 23, 24 auch nicht unbedingt Snapelemente aufweisen. Die Kopplungselemente 23, 24 können anstelle der Snaphaken 233, 234, 243, 244 auch Klammern umfassen.

Es ist auch möglich, dass die Montageeinheit 20 mit einem Kopplungselement ähnlich dem Kopplungselement 23 und/oder dem Kopplungselement 24 an die Montageplatte 12 gekoppelt wird.

Die Montageeinheit 20 kann zusätzlich zu der Montageeinheitöffnung 29 des ersten Ausführungsbeispiels die Montageeinheitlaschen 31, 32 mit den Montageeinheitöffnungen 29a, 29b des zweiten Ausführungsbeispiels aufweisen. Die Montageeinheitlaschen 31, 32 können auch jeweils mehr als eine Montageeinheitöffnung 29a, 29b aufweisen.

Auch wenn bei dem zweiten Ausführungsbeispiel die Montageeinheitlaschen 31, 32 bzw. die Montageeinheitöffnungen 29a, 29b an den schmaleren Seiten der Montageeinheit 20 angeordnet sind, können die Montageeinheitlaschen 31, 32 bzw. die Montageeinheitöffnungen 29a, 29b auch an den breiteren Seiten der Montageeinheit 20 angeordnet sein. Die Montageeinheitlaschen 31, 32 bzw. die Montageeinheitöffnungen 29a, 29b können auch sowohl an den schmalen und den breiten Seiten der Montageeinheit 20 angeordnet sein.

Die Montageeinheit 20 kann aus einem beliebigen geeigneten Werkstoff gefertigt sein, wie beispielsweise Kunststoff, Metall, Holz, usw. oder aus Kombinationen dieser oder anderer geeigneter Werkstoffe.

### Bezugszeichenliste

- 1: Schaltschrank
- 10: Linke Tür
- 11: Rechte Tür
- 12: Montageplatte
- 13: Leitungskanal
- 14: Montageschiene
- 15: Elektrisches Gerät, Reihenklemme
- 20: Montageeinheit
- 21: Grundkörper
- 211, 212: Trennelement
- 22: Aussparung
- 23: Erstes Kopplungselement
- 25: Erster Steg
- 26: Erster Bolzen
- 231, 232: Snapelemente des ersten Kopplungselements
- 233, 234: Snaphaken des ersten Kopplungselements
- 235, 236: Anderes Ende des ersten Kopplungselements
- 24: Zweites Kopplungselement
- 241, 242: Snapelement des zweiten Kopplungselements
- 243, 244: Snaphaken des zweiten Kopplungselements
- 245, 246: anderes Ende des zweiten Kopplungselements
- 27: Zweiter Steg
- 28: Zweiter Bolzen
- 29, 29a, 29b: Erste Montageeinheitöffnung
- 30: Zweite Montageeinheitöffnung
- 31: Erste Montageeinheitlasche
- 32: Zweite Montageeinheitlasche
- 35: Montageplatten-Befestigungselement
- 41: Erste Montageschienenöffnung
- 42: Zweite Montageschienenöffnung
- A: Erste Nut
- B: Zweite Nut
- S1, S2, S3: Verfahrensschritte

## Patentansprüche

1. Montageeinheit (20) zur Montage einer Montageschiene (14) für elektrische Geräte (15) an einer Montageplatte (12) für einen Schaltschrank (1), mit
einem Kopplungselement (23, 24) zum Koppeln der Montageeinheit (20) mittels Formschluss mit der Montageschiene (14), die eine Montageschienenöffnung (41, 42) aufweist,
wobei das Kopplungselement (23, 24) zum Koppeln der Montageeinheit (20) mit der Montageschienenöffnung (41, 42) ausgestaltet ist,
wobei das Kopplungselement (23, 24) zum Erreichen des Formschlusses mit der Montageschienenöffnung (41, 42) derart an der Montageeinheit (20) angeordnet ist, dass das Kopplungselement (23, 24) zur Kopplung mit der Montageschienenöffnung (41, 42) an einem Rand der Montageschienenöffnung (41, 42) in Richtung der Länge der Montageschiene (14) verhakbar ist,
wobei das Kopplungselement (23, 24) ein Snapelement (231, 232, 241, 242) zum Bilden einer Snapverbindung mit einer Montageschienenöffnung (41, 42) umfasst,
wobei das Snapelement (231, 232, 241, 242) als zwei blattfederförmige Teile ausgebildet ist, die an ihrem einen Ende jeweils mit einem Grundkörper (21) der Montageeinheit (20) verbunden sind und an ihrem anderen Ende einen Snaphaken (233, 234, 243,244) aufweisen,
wobei die zwei blattfederförmigen Teile durch ein Trennelement (211) des Grundkörpers (21) beabstandet voneinander sind, wobei die Snaphaken (233, 234, 243, 244) abgewandt voneinander angeordnet sind.

2. Montageeinheit (20) nach Anspruch 1, zudem mit einer Montageeinheitöffnung (29, 29a, 29b, 30) zur Aufnahme eines Montageplatten-Befestigungselements (35) zur Befestigung der Montageeinheit (20) an der Montageplatte (12), wobei das Kopplungselement (23, 24) zum Koppeln der Montageeinheit (20) mit der Montageschienenöffnung (41, 42) ausgestaltet ist.

3. Montageeinheit (20) nach Anspruch 1 oder 2, zudem mit einem wannenförmigen Grundkörper (21), der eine U-förmige Aussparung (22) zum Umgreifen der Montageschiene (14) aufweist.

4. Montageeinheit (20) nach einem der vorangehenden Ansprüche, wobei die zwei blattfederförmigen Teile durch eine vom Snaphaken (233, 234, 243, 244) zum Grundkörper (21) hin konisch zulaufende Nut (A, B) beabstandet voneinander sind, wobei die Snaphaken (233, 234, 243, 244) jeweils von der Nut (A, B) abgewandt angeordnet sind.

5. Montageeinheit (20) nach einem der vorangehenden Ansprüche, zudem mit einem Steg (25, 27), aus welchem ein Bolzen (26, 28) auskragt, wobei der Bolzen (26, 28) dem Kopplungselement (23, 24) zugeordnet ist.

6. Montageeinheit (20) nach einem der vorangehenden Ansprüche, wobei die Montageeinheit (20) zwei Kopplungselemente (23, 24) und/oder zwei Stege (25, 27) aufweist.

7. Montageeinheit (20) nach Anspruch 6, wobei in dem Grundkörper (21) ein erstes Kopplungselement (23), ein erster Steg (25) mit Bolzen (26), ein zweiter Steg (27) mit Bolzen (28) und ein zweites Kopplungselement (24) benachbart zueinander in einer Reihe angeordnet sind, wobei die Reihe quer zu der U-förmigen Aussparung angeordnet ist.

8. Montageeinheit (20) nach Anspruch 7,
wobei die Montageeinheitöffnung (29, 29a, 29b, 30) zwischen dem ersten Steg (25) mit Bolzen (26) und dem zweiten Steg (27) mit Bolzen (28) angeordnet ist, oder
wobei die Montageeinheit (20) eine erste und eine zweite Montageeinheitöffnung (29, 29a, 29b, 30) aufweist, und wobei an dem Grundkörper (21) die erste Montageeinheitöffnung (29, 29a, 29b), das erste Kopplungselement (23), der erste Steg (25) mit Bolzen (26), der zweite Steg (27) mit Bolzen (28), das zweite Kopplungselement (24) und die zweite Montageeinheitöffnung (30) benachbart zueinander in einer Reihe angeordnet sind.

9. Montageplatte (12) für einen Schaltschrank (1), mit mindestens einer Montageeinheit (20) nach einem der vorangehenden Ansprüche, wobei die Montageeinheit (20) zur Montage an einer Hutschiene oder einer C-Schiene für elektrische Geräte (15) dient.

10. System für einen Schaltschrank (1), mit
einer Montageplatte (12) nach Anspruch 9, an welcher mindestens eine Montageeinheit (20) nach einem der Ansprüche 1 bis 8 montiert ist, und
einer Montageschiene (14), an welcher mindestens ein elektrisches Gerät (15) und die Montageeinheit (20) montiert sind, wobei die Montageschiene (14) mittels der Montageeinheit (20) an der Montageplatte (12) befestigbar ist.

11. Verfahren zur Montage einer Montageschiene (14) an einer Montageplatte (12) für einen Schaltschrank (1), mit den Schritten
Bestücken (S1) einer Montageschiene (14), die eine Montageschienenöffnung (41, 42) aufweist, mit mindestens einem elektrischen Gerät (15),
Befestigen (S2) einer Montageeinheit (20) gemäß Anspruch 1 mit einem Montageplatten-Befestigungselement (35), das an einer Montageeinheitöffnung (29, 29a, 29b, 30) aufgenommen wird, an der Montageplatte (12), und
Montieren (S3) der Montageeinheit (20) an der Montageschiene (14), indem ein Kopplungselement (23, 24) mittels Formschluss mit der Montageschienenöffnung (41, 42) der Montageschiene (14) gekoppelt wird, wobei das Kopplungselement (23, 24) ein Snapelement (231, 232, 241, 242) zum Bilden einer Snapverbindung mit einer Montageschienenöffnung (41, 42) umfasst, wobei das Snapelement (231, 232, 241, 242) als zwei blattfederförmige Teile ausgebildet ist, die an ihrem einen Ende jeweils mit einem Grundkörper (21) der Montageeinheit (20) verbunden sind und an ihrem anderen Ende einen Snaphaken (233, 234, 243,244) aufweisen, wobei die zwei blattfederförmigen Teile durch ein Trennelement (211) des Grundkörpers (21) beabstandet voneinander sind, und wobei die Snaphaken (233, 234, 243, 244) abgewandt voneinander angeordnet sind,
wobei das Kopplungselement (23, 24) zum Erreichen des Formschlusses mit der Montageschienenöffnung (41, 42) derart an der Montageeinheit (20) angeordnet wird, dass das Kopplungselement (23, 24) zur Kopplung mit der Montageschienenöffnung (41, 42) an einem Rand der Montageschienenöffnung (41, 42) in Richtung der Länge der Montageschiene (14) verhakt wird, und
wobei die Schritte des Bestückens (S1), des Befestigens (S2) und des Montierens (S3) in einer beliebigen Reihenfolge ausführbar sind.

12. Verfahren nach Anspruch 11, wobei bei dem Schritt des Montierens (S3) das Kopplungselement (23, 24) und ein Bolzen (26, 28), der aus einem Steg (25, 27) der Montageeinheit (20) auskragt, an der Montageschienenöffnung (41, 42) aufgenommen werden.

## Claims

1. A mounting unit (20) for mounting a mounting rail (14) for electrical devices (15) on a mounting plate (12) for a switch cabinet (1), the mounting unit (20) comprising
a coupling element (23, 24) for coupling the mounting unit (20) by a form closure with the mounting rail (14), which comprises a mounting rail opening (41, 42),
wherein the coupling element (23, 24) is configured for coupling the mounting unit (20) with the mounting rail opening (41, 42),
wherein the coupling element (23, 24), for achieving the form closure with the mounting rail opening (41, 42), is positioned on the mounting unit (20) such that the coupling element (23, 24), for coupling with the mounting rail opening (41, 42), can get caught at one edge of the mounting rail opening (41, 42) in the direction of the length of the mounting rail (14),
wherein the coupling element (23, 24) comprises a snap element (231, 232, 241, 242) for forming a snap connection with a mounting rail opening (41, 42),
wherein the snap element (231, 232, 241, 242) is formed as two parts each formed like a flat spring and each connected at one end with a basic body (21) of the mounting unit (20) and comprising at its other end a snap hook (233, 234, 243, 244),
wherein the two snap hooks (233, 234, 243, 244) formed like a flat spring are spaced from each other by a spacing element (211) of the basic body (21), wherein the snap hooks (233, 234, 243, 244) are positioned averted from each other.

2. The mounting unit (20) according to claim 1, further comprising a mounting unit opening (29, 29a, 29b, 30) for receiving a mounting plate fastening element (35) for fastening the mounting unit (20) to the mounting plate (12), wherein the coupling element (23, 24) is configured for coupling the mounting unit (20) with the mounting rail opening (41, 42).

3. The mounting unit (20) according to claim 1 or 2, further comprising a trough-shaped basic body (21) which comprises a U-shape recess (22) for encompassing the mounting rail (14).

4. The mounting unit (20) according to one of the preceding claims, wherein the two parts formed like a flat spring are spaced from each other by a notch (A, B) tapered from the snap hook (233, 234, 243, 244) to the basic body, wherein each one of the snap hooks (233, 234, 243, 244) is positioned averted from the notch (A, B).

5. The mounting unit (20) according to one of the preceding claims, further comprising a bar (25, 27) from which a bolt (26, 28) protrudes, wherein the bolt (26, 28) is allocated to the coupling element (23, 24).

6. The mounting unit (20) according to one of the preceding claims, wherein the mounting unit (20) comprises two coupling elements (23, 24) and/or two bars (25, 27).

7. The mounting unit (20) according to claim 6, wherein a first coupling element (23), a first bar (25) with bolt (26), a second bar (27) with bolt (28), and a second coupling element (24) are positioned adjacent to each other in a row in the basic body (21), wherein the row is positioned transverse to the U-shaped recess.

8. The mounting unit (20) according to claim 7,
wherein the mounting unit opening (29, 29a, 29b, 30) is positioned between the first bar (25) with bolt (26) and the second bar (27) with bolt (28), or
wherein the mounting unit (20) comprises a first and a second mounting unit opening (29, 29a, 29b, 30), and wherein the first mounting unit opening (29, 29a, 29b), the first coupling element (23), the first bar (25) with bolt (26), the second bar (27) with bolt (28), the second coupling element (24), and the second mounting unit opening (30) are positioned adjacent to each other in a row at the basic body (21).

9. A mounting plate (12) for a switch cabinet (1), comprising at least one mounting unit (20) according to one of the preceding claims, wherein the mounting unit (20) acts for mounting to a cap rail or a C-rail for electrical devices (15).

10. A system for a switch cabinet (1), comprising
a mounting plate (12) according to claim 9, to which is mounted at least one mounting unit (20) according to one of the claims 1 to 8, and
a mounting rail (14) to which is mounted at least one electrical device (15) and the mounting unit (20), wherein the mounting rail (14) can be fastened by means of the mounting unit (20) to the mounting plate (12).

11. A method for mounting a mounting rail (14) to a mounting plate (12) for a switch cabinet (1), the method comprising the steps of
equipping (S1) a mounting rail (14) with at least one electrical device (15), the mounting rail (14) comprising a mounting rail opening (41, 42),
fastening (S2) a mounting unit (20) according to claim 1 on the mounting plate (12) by means of a mounting plate fastening element (35) that is received in a mounting unit opening (29, 29a, 29b, 30), and
mounting (S3) the mounting unit (20) on the mounting rail (14) by coupling a coupling element (23, 24) by means of a form closure with the mounting rail opening (41, 42) of the mounting rail (14), wherein the coupling element (23, 24) comprises a snap element (231, 232, 241, 242) for forming a snap connection with a mounting rail opening (41, 42), wherein the snap element (231, 232, 241, 242) is formed as two parts each formed like a flat spring and each connected at one end with a basic body (21) of the mounting unit (20) and comprising at its other end a snap hook (233, 234, 243, 244), wherein the two snap hooks (233, 234, 243, 244) formed like a flat spring are spaced from each other by a spacing element (211) of the basic body (21), and wherein the snap hooks (233, 234, 243, 244) are positioned averted from each other,
wherein the coupling element (23, 24), for achieving the form closure with the mounting rail opening (41, 42), is positioned on the mounting unit (20) such that the coupling element (23, 24), for coupling with the mounting rail opening (41, 42), gets caught at one edge of the mounting rail opening (41, 42) in the direction of the length of the mounting rail (14), and
wherein the steps of equipping (S1), fastening (S2), and mounting (S3) are executable in an arbitrary order.

12. The method according to claim 11, wherein the coupling element (23, 24) and a bolt (26, 28), which protrudes from a bar (25, 27) of the mounting unit (20), are received in the mounting rail opening (41, 42) in the step of mounting (S3).

## Revendications

1. Unité de montage (20) pour le montage d'un rail de montage (14) pour des dispositifs électriques (15) sur une plaque de montage (12) pour une armoire de commande (1), l'unité de montage (20) comprenant
un élément d'accouplement (23, 24) destiné à accoupler l'unité de montage (20) par coopération de formes avec le rail de montage (14), qui comprend une ouverture de rail de montage (41, 42),
dans laquelle l'élément d'accouplement (23, 24) est configuré pour accoupler l'unité de montage (20) à l'ouverture de rail de montage (41, 42),
dans laquelle l'élément d'accouplement (23, 24), pour obtenir la coopération de formes avec l'ouverture de rail de montage (41, 42), est positionné sur l'unité de montage (20) de telle sorte que l'élément d'accouplement (23, 24), pour l'accouplement à l'ouverture de rail de montage (41, 42), peut être accroché à un bord de l'ouverture de rail de montage (41, 42) dans la direction de la longueur du rail de montage (14),
dans laquelle l'élément d'accouplement (23, 24) comprend un élément d'encliquetage (231, 232, 241, 242) destiné à former une liaison d'encliquetage avec une ouverture de rail de montage (41, 42),
dans laquelle l'élément d'encliquetage (231, 232, 241, 242) est réalisé sous la forme de deux parties formées chacune comme un ressort plat et raccordées chacune à une extrémité à un corps de base (21) de l'unité de montage (20) et comprenant à leur autre extrémité un crochet d'encliquetage (233, 234, 243, 244),
dans laquelle les deux crochets d'encliquetage (233, 234, 243, 244) formés comme un ressort plat sont espacés l'un de l'autre par un élément d'espacement (211) du corps de base (21), dans laquelle les crochets d'encliquetage (233, 234, 243, 244) sont positionnés à l'opposé l'un de l'autre.

2. Unité de montage (20) selon la revendication 1, comprenant en outre une ouverture d'unité de montage (29, 29a, 29b, 30) destinée à recevoir un élément de fixation de plaque de montage (35) destiné à fixer l'unité de montage (20) à la plaque de montage (12), dans laquelle l'élément d'accouplement (23, 24) est configuré pour accoupler l'unité de montage (20) à l'ouverture de rail de montage (41, 42).

3. Unité de montage (20) selon la revendication 1 ou 2, comprenant en outre un corps de base (21) en forme de cuvette qui comprend un évidement en forme de U (22) destiné à englober le rail de montage (14).

4. Unité de montage (20) selon l'une quelconque des revendications précédentes, dans laquelle les deux parties formées comme un ressort plat sont espacées l'une de l'autre par une encoche (A, B) à section décroissante du crochet d'encliquetage (233, 234, 243, 244) au corps de base, dans laquelle chacun des crochets d'encliquetage (233, 234, 243, 244) est positionné à l'opposé de l'encoche (A, B).

5. Unité de montage (20) selon l'une quelconque des revendications précédentes, comprenant en outre une barre (25, 27) dont un boulon (26, 28) fait saillie, dans laquelle le boulon (26, 28) est alloué à l'élément d'accouplement (23, 24).

6. Unité de montage (20) selon l'une quelconque des revendications précédentes, dans laquelle l'unité de montage (20) comprend deux éléments d'accouplement (23, 24) et/ou deux barres (25, 27).

7. Unité de montage (20) selon la revendication 6, dans laquelle un premier élément d'accouplement (23), une première barre (25) avec boulon (26), une deuxième barre (27) avec boulon (28), et un deuxième élément d'accouplement (24) sont positionnés de manière adjacente l'un à l'autre en rang dans le corps de base (21), dans laquelle le rang est positionné de manière transversale par rapport à l'évidement en forme de U.

8. Unité de montage (20) selon la revendication 7,
dans laquelle l'ouverture d'unité de montage (29, 29a, 29b, 30) est positionnée entre la première barre (25) avec boulon (26) et la deuxième barre (27) avec boulon (28), ou
dans laquelle l'unité de montage (20) comprend une première et une deuxième ouverture d'unité de montage (29, 29a, 29b, 30), et dans laquelle la première ouverture d'unité de montage (29, 29a, 29b), le premier élément d'accouplement (23), la première barre (25) avec boulon (26), la deuxième barre (27) avec boulon (28), le deuxième élément d'accouplement (24), et la deuxième ouverture d'unité de montage (30) sont positionnés de manière adjacente les uns aux autres en rang au niveau du corps de base (21).

9. Plaque de montage (12) pour une armoire de commande (1), comprenant au moins une unité de montage (20) selon l'une quelconque des revendications précédentes, dans laquelle l'unité de montage (20) sert à être montée sur un profilé chapeau ou un rail en C pour des profilés électriques (15).

10. Système pour une armoire de commande (1), comprenant
une plaque de montage (12) selon la revendication 9, sur laquelle est montée au moins une unité de montage (20) selon l'une quelconque des revendications 1 à 8, et
un rail de montage (14) sur lequel sont montés au moins un dispositif électrique (15) et l'unité de montage (20), dans lequel le rail de montage (14) peut être fixé au moyen de l'unité de montage (20) à la plaque de montage (12).

11. Procédé de montage d'un rail de montage (14) sur une plaque de montage (12) pour une armoire de commande (1), le procédé comprenant les étapes
d'équipement (S1) d'un rail de montage (14) d'au moins un dispositif électrique (15), le rail de montage (14) comprenant une ouverture de rail de montage (41, 42),
de fixation (S2) d'une unité de montage (20) selon la revendication 1 sur la plaque de montage (12) au moyen d'un élément de fixation de plaque de montage (35) qui est reçu dans une ouverture d'unité de montage (29, 29a, 29b, 30), et
de montage (S3) de l'unité de montage (20) sur le rail de montage (14) par accouplement d'un élément d'accouplement (23, 24) au moyen d'une coopération de formes avec l'ouverture de rail de montage (41, 42) du rail de montage (14), dans lequel l'élément d'accouplement (23, 24) comprend un élément d'encliquetage (231, 232, 241, 242) destiné à former une liaison par encliquetage avec une ouverture de rail de montage (41, 42), dans lequel l'élément d'encliquetage (231, 232, 241, 242) est réalisé sous la forme de deux parties formées chacune comme un ressort plat et raccordées chacune à une extrémité à un corps de base (21) de l'unité de montage (20) et comprenant à leur autre extrémité un crochet d'encliquetage (233, 234, 243, 244), dans lequel les deux crochets d'encliquetage (233, 234, 243, 244) formés comme un ressort plat sont espacés l'un de l'autre par un élément d'espacement (211) du corps de base (21), et dans lequel les crochets d'encliquetage (233, 234, 243, 244) sont positionnés à l'opposé l'un de l'autre, dans lequel l'élément d'accouplement (23, 24), pour obtenir la coopération de formes avec l'ouverture de rail de montage (41, 42), est positionné sur l'unité de montage (20) de telle sorte que l'élément d'accouplement (23, 24), pour l'accouplement à l'ouverture de rail de montage (41, 42), est accroché à un bord de l'ouverture de rail de montage (41, 42) dans la direction de la longueur du rail de montage (14), et
dans lequel les étapes d'équipement (S1), de fixation (S2), et de montage (S3) peuvent être exécutées dans un ordre arbitraire.

12. Procédé selon la revendication 11, dans lequel l'élément d'accouplement (23, 24) et un boulon (26, 28), qui fait saillie d'une barre (25, 27) de l'unité de montage (20), sont reçus dans l'ouverture de rail de montage (41, 42) à l'étape de montage (S3).
